# FASCICULE DE BREVET EUROPEEN

(11) **EP 2 832 683 B1**
(45) Date de publication et mention de la délivrance du brevet: **27.07.2016**
(21) Numéro de dépôt: 14178971.9
(22) Date de dépôt: 29.07.2014
(51) Int. Cl.: B81B 7/00

(54) **Dépôt par enduction centrifuge d'une couche mince structurée sur un substrat**
Aufbringung durch Tauchschleudern einer strukturierten Dünnschicht auf einem Substrat
Spin coating deposition of a thin structured layer on a substrate

(30) Priorité: 29.07.2013 FR 1301818
(43) Date de publication de la demande: 04.02.2015
(73) Titulaire: Commissariat à l'Energie Atomique et aux Energies Alternatives, 75015 Paris (FR)
(72) Inventeur: Sebastien, Thomas, 38950 Saint-Martin-Le-Vinoux (FR); Bedjaoui, Messaoud, 38340 Voreppe (FR); Ennajdaoui, Aboubakr, 63100 Clermont-Ferrand (FR)
(74) Mandataire: Talbot, Alexandre

(56) Documents cités:
- JP-A- 2007 298 971
- US-A1- 2010 183 866
- US-A1- 2013 037 929

## Description

### Domaine technique de l'invention

L'invention est relative à un procédé de réalisation d'une couche structurée à l'aide d'un dépôt par enduction centrifuge.

### État de la technique

Dans le domaine des micro et nanotechnologies les procédés de réalisation de couches structurées, selon des formes géométriques prédéterminées, connaissent une évolution incessante. En effet, la structuration de couches minces offre un large spectre d'applications intéressantes, notamment pour réaliser des structures nanométriques ou micrométriques destinées à former des dispositifs microélectroniques, optiques, ou encore biotechnologiques.

Par ailleurs, des couches à base de résine sont utilisées dans la plupart des procédés de fabrication des dispositifs micro et/ou nanométriques. Le dépôt de couches minces en résine sur un substrat se fait, de manière générale, par enduction centrifuge (« spin-coating » selon la terminologie usuelle anglo-saxonne). Cette technique, permet le dépôt d'une couche homogène avec un contrôle précis de son épaisseur.

La variété de la composition des différents types de résine et de leurs propriétés mécaniques, chimiques, thermiques et optiques permet leur utilisation pour de nombreuses applications. En fonction de l'application visée, les couches en résine peuvent assurer par exemple des fonctions d'encapsulation, d'isolation électrique ou thermique, de passivation, d'aplanissement, etc.

Dans certaines utilisations, une couché mince en résine est structurée à l'échelle micrométrique et/ou nanométrique. Cette structuration peut être réalisée suivant plusieurs techniques.

A titre d'exemple, la structuration par laser est une technique d'ablation laser qui permet de générer des motifs en surface ou en volume dans une couche en résine. Les caractéristiques géométriques du motif structuré qui est formé dans la couche en résine varient en fonction de la puissance, du diamètre et de la longueur d'onde du faisceau ainsi que la durée d'exposition.

Une couche mince à base d'une résine peut également être structurée par une technique faisant intervenir un tampon structuré, telle que la structuration par impression, moulage ou emboutissage (communément appelées techniques de « soft lithography »).

Par ailleurs; les techniques de photolithographie peuvent être utilisées pour structurer une couche mince en résine. Ce sont des techniques classiques utilisées en microélectronique pour structurer des couches minces en formant deux matériaux différents. Par exemple, pour structurer une couche mince en polymère une résine photosensible est déposée, puis insolée avec un rayonnement électromagnétique selon un dessin particulier et développée. Ensuite, la couche mince en polymère est gravée à travers le motif réalisé dans la résine photosensible qui sera éliminée après cette étape de gravure.

Les techniques de structuration de couches minces en résine, décrites ci-dessus, restent cependant des techniques coûteuses nécessitant un nombre élevé d'étapes à réaliser et/ou un temps conséquent pour être mises en oeuvre. Par ailleurs, ces techniques utilisent des appareils de haute-technologie nécessitant un environnement et une installation spécifiques.

### Objet de l'invention

L'invention a pour objet un procédé de réalisation d'une couche structurée facile à mettre en oeuvre, et permettant une homogénéité et un control précis de l'épaisseur et de la topographie de la couche structurée.

On tend vers cet objet en prévoyant un procédé de réalisation d'une couche structurée en premier matériau sur une face d'un substrat en disposant une particule sur la face du substrat. Ensuite, une résine est déposée par enduction centrifuge sur la face du substrat de manière à former la couche structurée en premier matériau et un trou traversant la couche en premier matériau et débouchant sur la particule. En outre, le matériau de la particule et la résine sont choisis de manière que la particule exerce une interaction répulsive vis-à-vis de la résine.

De manière préférentielle, l'épaisseur de la couche structurée est supérieure à la dimension de la particule selon un axe sensiblement perpendiculaire à la face du substrat.

Selon un développement, la couche structurée en premier matériau est réticulée après l'étape de dépôt par enduction centrifuge. Préférentiellement, la couche structurée en premier matériau subit une étape de traitement thermique.

Selon un mode de réalisation, le procédé comporte une élimination de la particule après la formation de la couche structurée en premier matériau.

Selon un autre mode de réalisation, le procédé comporte la disposition d'au moins une particule additionnelle sur la face du substrat de manière que la particule et la particule additionnelle soient localisées à des première et deuxième positions prédéterminées de la face du substrat. Par ailleurs, le matériau de la particule additionnelle est choisi de manière que la particule additionnelle exerce une interaction répulsive vis-à-vis de la résine de sorte à former un trou additionnel traversant la couche en premier matériau et débouchant sur la particule additionnelle. Avantageusement, les première et deuxième positions prédéterminées sont choisies de manière que le trou traversant et le trou traversant additionnel se chevauchent.

Selon un mode de réalisation supplémentaire, le trou traversant comporte des parois latérales et la couche structurée en premier matériau comporte une surface libre opposée à la face du substrat. Les parois latérales et la surface libre sont reliées par un bourrelet en premier matériau. Selon ce mode de réalisation, le procédé comporte une gravure anisotrope du premier matériau pour former un motif fermé continu et représentatif du pourtour du trou.

On prévoit également un composant électronique disposé sur une face d'un substrat, et comportant :
- un premier plot de contact électrique ;
- une première couche d'encapsulation en matériau polymère électriquement isolant disposée sur la face et munie d'une surface opposée à la face, ladite première couche étant conformée de sorte à comporter un trou traversant débouchant sur le plot ;
- un deuxième plot en matériau électriquement conducteur, disposé sur le premier plot et localisé dans le trou ;
- une deuxième couche d'encapsulation électriquement conductrice disposée sur la surface, les première et deuxième couches d'encapsulation formant une bicouche recouvrant totalement le composant à l'exception du deuxième plot.

En outre, le trou traversant comporte des parois latérales reliées à la surface par un bourrelet en matériau polymère électriquement isolant, le bourrelet séparant latéralement le deuxième plot et la deuxième couche d'encapsulation.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 3c illustrent, de manière schématique, en vue de coupe, des étapes de réalisation d'une couche structurée sur un substrat, par enduction centrifuge selon un premier mode de mise en oeuvre;
- la figure 4 illustre, de manière schématique, en vue de coupe, un agrandissement d'un trou formé dans la couche structuré de la figure 3c ;
- les figures 5a et 5b illustrent, de manière schématique, en vue de coupe, des étapes de réalisation de bourrelets en saillie sur un substrat à partir de la couche structurée de la figure 3c ;
- la figure 6 illustre, de manière schématique, en vue de coupe, une couche structurée réalisée selon un autre mode de mise en oeuvre;
- la figure 7a illustre, de manière schématique, en vue de dessus un dispositif électronique selon un mode de réalisation ;
- la figure 7b illustre, de manière schématique, en vue de coupe de la figure 7a selon l'axe AA ;
- les figures 8a à 8c illustrent, de manière schématique, en vue de coupe, des étapes de réalisation d'une couche structurée sur un substrat, par enduction centrifuge selon un autre mode de mise en oeuvre.

### Description de modes préférentiels de réalisation

Dans le domaine des micro et nanotechnologies, il existe un besoin de réaliser facilement sur un substrat, une couche structurée à base d'une résine, tout en contrôlant avec précision son épaisseur et sa topographie. On tend à satisfaire ce besoin en prévoyant un procédé de réalisation par enduction centrifuge d'une couche structurée à base d'une résine.

Selon un premier mode de réalisation illustré aux figures allant de 1 à 3c, le procédé comporte la fourniture d'un substrat 10 comportant une face 11.

Le procédé comporte une étape de disposition d'une particule 12 sur la face 11 du substrat 10. Ensuite, un dépôt par enduction centrifuge d'une résine 13 sur la face 11 du substrat 10 est réalisé. La résine 13 peut être également déposée sur la particule 12. Par résine dans cet écrit, on entend un fluide à base d'un matériau polymère.

La résine 13 est une résine configurée pour être déposée par enduction centrifuge sur le substrat 10 pour former une couche à base de cette dernière.

De préférence, la résine 13 possède une faible viscosité, c'est-à-dire une viscosité dynamique mesurée à 300 K comprise entre quelques dizaines et quelques centaines de centipoises. Par ailleurs, de manière plus préférentielle, la résine 13 est une résine viscoélastique. Selon un exemple de réalisation, la viscosité d'une résine époxy référencée OG146-178 et commercialisée par Epoxy Technology a été mesurée par un rhéomètre de marque MCR 300 sous exploitation d'Anton Paar. La viscosité a été mesurée à 300 K, en réalisant 31 points de mesure avec un intervalle de 5 s entre chaque deux points de mesure. Selon ces conditions de mesure, une viscosité d'environ 165 centipoises a été mesurée pour la résine OG146-178.

D'une manière générale, la résine 13 peut être une résine photo ou thermo-polymérisable utilisée de manière usuelle dans le domaine de la microélectronique. En outre, la résine 13 peut être, par exemple, une résine polyester insaturé-styrène, une résine thiol-polyènes, une résine acrylate ou méthacrylate, une résine époxyde, une résine éther vinylique ou propénylique, on encore un système hybride à base d'un mélange de ce type de résine.

Le substrat 10 est un substrat compatible avec la méthode de dépôt par enduction centrifuge. Le substrat 10 est généralement un substrat utilisé dans le domaine de la microélectronique, tel qu'un substrat de silicium, de verre, de micas, etc. Préférentiellement, le substrat 10 comporte une face 11 ayant des propriétés de surface, notamment un paramètre d'adhérence, adaptées au dépôt par enduction centrifuge de la résine 13 pour former une couche 14 en premier matériau. Par « paramètre adhérence », on entend un état de surface favorable à l'étalement de la résine pour la formation d'un film homogène et mince. Ce paramètre est d'autant plus élevé que l'aptitude de la résine à établir des liaisons de type hydrogènes (ou Van Der Waals) avec la surface du substrat est élevée. En outre, la face 11 du substrat 10 peut comporter des dispositifs, ayant des dimensions micro ou nanométriques. De manière préférentielle, les propriétés de surface desdits dispositifs sont compatibles avec le dépôt de la résine 13, et leur dimension selon un axe (Oz) sensiblement perpendiculaire à la face 11 du substrat 10, est inférieure à l'épaisseur de la couche 14 en premier matériau.

Préférentiellement, le substrat 10 est nettoyé avant la disposition de la particule 12, de taille micro ou nanométrique. Cette étape de nettoyage permet de manière avantageuse d'éviter la contamination du substrat 10.

Selon un exemple de réalisation, le substrat 10 est un substrat de silicium ayant une rugosité RMS inférieur à 3 nm, et préférentiellement inférieure ou sensiblement égale à 1 nm. La rugosité RMS (en anglais « Root Mean Square ») correspond à la valeur de l'écart quadratique moyen de la rugosité sur une surface balayée du substrat de quelques µm².

Par ailleurs, le matériau de la particule 12 et la résine 13 sont choisis de manière que la particule 12 exerce une interaction répulsive vis-à-vis de la résine 13, d'un point de vue mouillabilité. L'interaction répulsive traduit la capacité à ne pas former de liaisons de type hydrogènes (ou Van Der Waals) entre la résine 13 et la particule 12, en considérant que la particule n'est pas chargée sur le plan macroscopique. Cette interaction répulsive résulte de la différence d'énergie de surface entre la résine 13 et la particule 12. La différence d'énergie de surface régit une rétraction spontanée de la résine 13 lors du dépôt par enduction centrifuge.

Autrement dit, la résine 13 doit être non mouillante vis-à-vis de la surface de la particule 12. A titre d'exemple, le choix du matériau d'une particule et d'une résine peut être fait en fonction de la mesure de l'angle de contact que forme une goutte de ladite résine avec une surface plane en matériau de ladite particule. Autrement dit, on évalue la mouillabilité de la résine vis-à-vis de ladite particule en réalisant cette expérience classique. Ainsi, pour un angle de contact mesuré supérieur strictement à 90 °, ladite résine et ledit matériau de la particule peuvent être choisis pour être utilisés dans le procédé.

On peut utiliser, par exemple, des microbilles d'oxycarbure de silicium (SiOC) en poudre avec une résine époxy, ou des microbilles en oxyde de zinc (ZnO) avec une résine en polyépoxyde thermo-réticulable, ou encore des billes de polystyrène avec une résine acrylate thermodurcissable.

Préférentiellement, la particule 12 est une particule non soluble dans la résine 13. Par ailleurs, la particule 12 peut avoir une forme géométrique quelconque et des dimensions micro ou nanométriques. Avantageusement, l'épaisseur de la couche structurée 14 est supérieure à la dimension de la particule 12 selon l'axe (Oz) sensiblement perpendiculaire à la face 11 du substrat 10. De manière préférentielle, la particule 12 a une forme sphérique et un diamètre inférieur à l'épaisseur de la couche 14 en premier matériau. La particule 12 a préférentiellement une dimension supérieure à 10 nm.

Par exemple, la particule 12 peut être une microbille en métal ou en oxyde, telle qu'une microbille en or ou en oxyde de zinc. La particule 12 peut également être à base d'un matériau organique, par exemple une microbille de polymère ou un amas de bio-polymères, ou encore des motifs micro ou nanométriques à base d'un polymère déposé sur le substrat 10.

En outre, la particule 12 peut être de taille nanométrique, par exemple elle peut être à base d'agrégats de petites molécules telles que l'oxyde de titane TiO₂ ou l'oxyde de zinc ZnO, d'atomes d'Or, ou à base de grosses molécules telles que les fullerènes ou encore des dendrimères. De façon générale, toutes les structures nanométriques présentant une certaine symétrie et pouvant donner lieu à une répulsion de la résine 13 peuvent être utilisées. Les nanoparticules permettent de manière avantageuse de moduler l'ampleur du caractère répulsif de la particule 12 vis-à-vis de la résine 13 choisie.

La disposition de la particule 12 sur la face 11 du substrat 10 peut être réalisée, en fonction de sa forme et de son matériau, selon plusieurs techniques. A titre d'exemple, on peut disperser plusieurs particules 12 sous forme de poudre sur la face 11 du substrat 10, ou encore étaler un solvant contenant des particules 12 à la surface du substrat puis procéder à une étape de séchage pour évaporer la phase liquide. La face 11 du substrat 10 peut également être exposée à une atmosphère inerte chargée en particules 12.

Selon l'exemple de réalisation, la particule 12 est une microbille de ZnO ayant un diamètre sensiblement égal à 1 µm. La particule 12 a été disposée sur la face 11 du substrat 10 par étalement d'une solution alcoolique contenant des microbilles de ZnO. La face 11 du substrat 10 est ensuite séchée à l'air pour évaporer le solvant et ne laisser à la face 11 que les microbilles de ZnO.

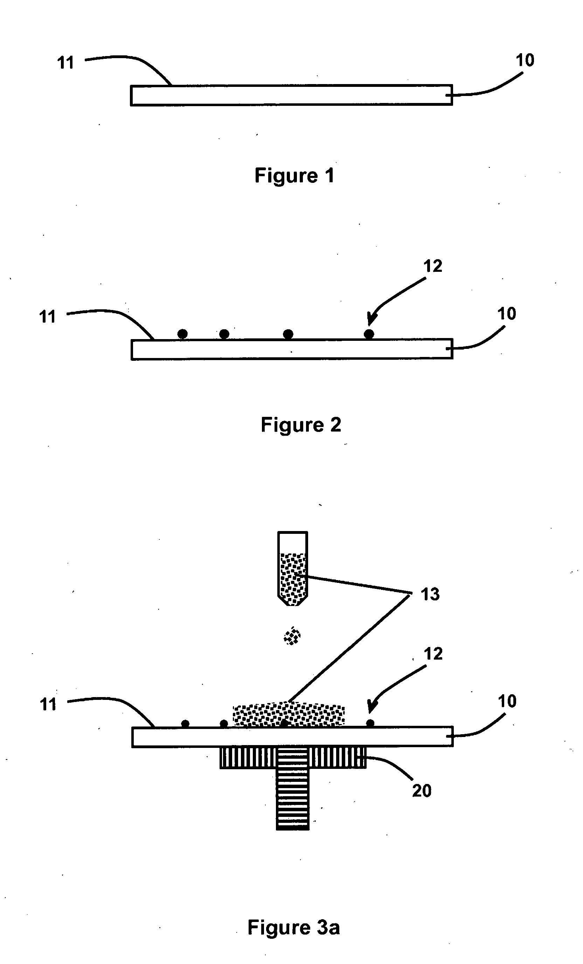

Comme illustré aux figures 3a à 3c, lors du dépôt par enduction centrifuge, le substrat 10 est fixé sur un support 20. Le substrat 10 est fixé sur le support 20 de manière que la face 11 soit libre. Le support 20 est configuré de sorte à pouvoir entraîner le substrat 10 dans un mouvement de rotation autour de l'axe (Oz) sensiblement perpendiculaire à la face 11 du substrat 10.

Par ailleurs, le substrat 10 peut être un substrat flexible fixé sur un substrat additionnel rigide et configuré pour être solidarisé sur le support 20 de manière à être entraîné dans un mouvement de rotation autour de l'axe (Oz). Par substrat flexible, on entend un substrat ayant une première valeur de rigidité largement inférieure à une deuxième valeur de rigidité du substrat additionnel. Par exemple, le substrat 10 peut être un substrat en métal revêtu d'une couche polyimide, ou en PolyEthylène Naphtalate (PEN).

Ensuite, la résine 13 est déposée sur la face 11 du substrat 10 (figure 3a). La résine 13 choisie peut être une résine photo ou thermo-réticulable pouvant être déposée par enduction centrifuge. Par exemple, la résine est un polymère polyépoxyde, polystyrene, etc.

Selon l'exemple de réalisation, la résine 13 est une résine en polyépoxyde photo-réticulable, ayant une faible viscosité de l'ordre de 200 cP (centipoise) mesurée à 23°C et en utilisant une vitesse de centrifugation de l'ordre de 100 rpm.

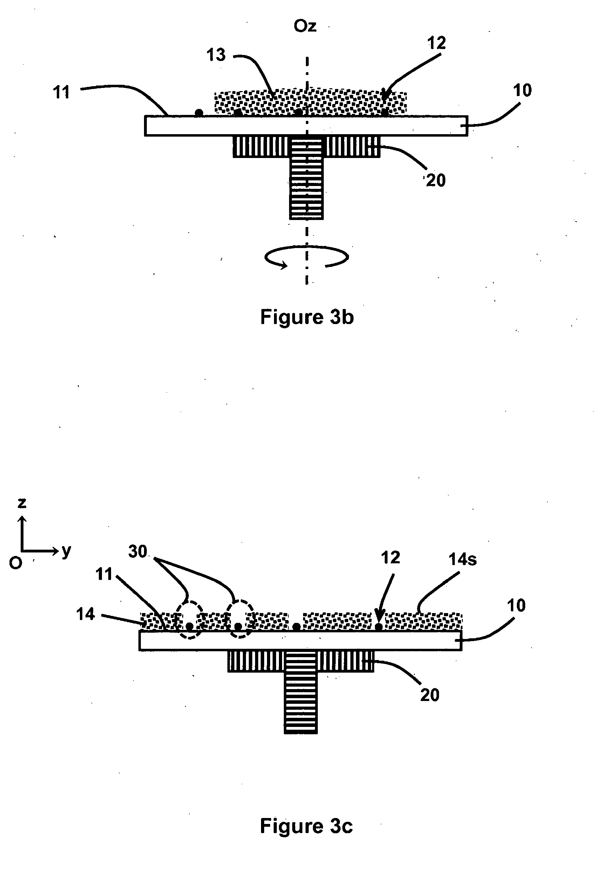

Le dépôt par enduction centrifuge peut comporter un premier mouvement de rotation du substrat 10 autour de l'axe (Oz) avec une première vitesse angulaire. Le premier mouvement de rotation peut être configuré de sorte à étaler la résine 13 sur la face 11 de sorte que la résine 13 recouvre la face 11. A titre d'exemple, le premier mouvement de rotation peut être réalisé pour recouvrir la face 11, et éventuellement dans un premier temps la particule 12, par la résine 13 en éjectant l'excès de la résine 13 sous forme de gouttelettes (figures 3b).

Le premier mouvement de rotation peut être suivi par un deuxième mouvement de rotation du substrat 10 autour de l'axe (Oz) avec une deuxième vitesse angulaire supérieure à la première vitesse.

Lorsque la résine 13 comporte un ou plusieurs solvants, le deuxième mouvement de rotation peut être mis à profit pour évaporer les solvants les plus volatils. Cette évaporation, peut être accompagnée par une diminution de l'épaisseur de la couche 14 résultant du dépôt par enduction centrifuge. Lors de l'étape d'enduction centrifuge, il y a formation des trous 30 (figure 3c).

Préférentiellement, le dépôt par enduction centrifuge est configuré de manière que l'épaisseur de la couche structurée 14 soit supérieure au double de la hauteur de la particule 12. Par hauteur, on entend la dimension selon l'axe (Oz) qui est sensiblement perpendiculaire à la face du substrat 10.

Le dépôt par enduction centrifuge de la résine 13 sur la face 11 du substrat 10 est réalisé de manière à former la couche 14 structurée en premier matériau, et un trou 30 traversant la couche 14 en premier matériau, et débouchant sur la particule 12 (figures 3a à 3c). En effet, la particule 12 engendre un démouillage de la résine 13, autour de la particule 12, lors du dépôt par enduction centrifuge. Ainsi, le trou 30 traversant la couche 14 en premier matériau est formé.

Grâce à son caractère répulsif vis-à-vis de la résine 13, la particule 12 permet de manière avantageuse le démouillage de la résine 13 et de ce fait la création du trou 30 dans la couche 14. Par ailleurs, la particule 12 permet une rupture de la planéité de la face 11 du substrat 10, ce qui facilite l'amorçage du phénomène de démouillage. Cependant, c'est le caractère répulsif de la particule 12 vis-à-vis de la résine 13, qui permet de former le trou 30 et de contrôler ses dimensions.

Avantageusement, la réalisation de la couche 14 en premier matériau sur le substrat 10 permet de combiner dépôt et structuration (réalisation de trous) de la couche 14, à une échelle micro et/ou nanométrique, au cours du dépôt par enduction centrifuge. Ce dépôt permet de ce fait, de manière avantageuse, un contrôle précis de l'épaisseur de la couche 14 en premier matériau ainsi que les dimensions du trou 30 formé.

Par ailleurs, la formation de la couche structurée 14 ne génère ni re-dépôt de matériaux, ni échauffement localisé, ni dégazage contrairement aux méthodes traditionnelles de gravure chimique, physique ou laser. En outre, le procédé de réalisation de la couche structurée en premier matériau est facile à mettre en oeuvre, peu onéreux, et nécessite peu d'étapes et de matériel.

Selon l'exemple de réalisation, les conditions du dépôt par enduction centrifuge de la résine 13 en polyépoxyde ont été configurées de sorte à réaliser sur le substrat 10 en silicium une couche 14 de 5 µm d'épaisseur. Le dépôt par enduction centrifuge a été réalisé en trois phases :
- une première phase d'accélération à 1000 rpm/s pour atteindre la première vitesse d'une valeur de 1200 rpm conservée pendant 130 s ;
- une seconde phase d'accélération à 4000 rpm/s pour atteindre la deuxième vitesse d'une valeur d'environ 2400 rpm conservée pendant 20 s ; et
- une phase de décélération brutale pour arrêter la rotation du substrat 10.

Dès lors, un étalement homogène et nivelé de la résine 13 en polyépoxyde est obtenu. En outre, le dépôt engendre un démouillage de la résine 13 autour des particules 12 en ZnO disposées sur la face 11 du substrat 10 en silicium, formant ainsi les trous 30.

La couche 14 obtenue est ensuite avantageusement insolée à une longueur d'onde d'environ 300 nm et une puissance de 100 mW/cm² pendant 5 minutes pour réticuler la couche 14 de polymère. Pour améliorer les propriétés structurelles et mécaniques de la couche 14 comportant les trous 30, la couche 14 a subi préférentiellement un traitement thermique à 75 °C pendant 15 minutes.

Dans cet exemple de réalisation, les trous 30 formés dans la couche de polymère 14 à base de polyépoxyde débouchent sur des portions de la face 11 du substrat 10, comportant chacune une particule 12 en ZnO. Ainsi, les trous mesurent environ 5 µm de hauteur et environ 10 µm de largeur. Les parois latérales 30l des trous 30 sont légèrement inclinées par rapport à la face avant 11. Par ailleurs, les trous 30 comportent des bourrelets 40 mesurant environ 1 µm de hauteur.

De manière préférentielle, plusieurs particules sensiblement identiques à la particule 12 sont disposées sur la face 11 de manière à former plusieurs trous sensiblement identiques au trou 30 dans la couche 14 en premier matériau. La réalisation de plusieurs trous aléatoirement distribués dans une couche mince peut être avantageusement utilisée pour former une couche poreuse, une structure alvéolée, ou encore une membrane ne laissant passer que certaines tailles de molécules.

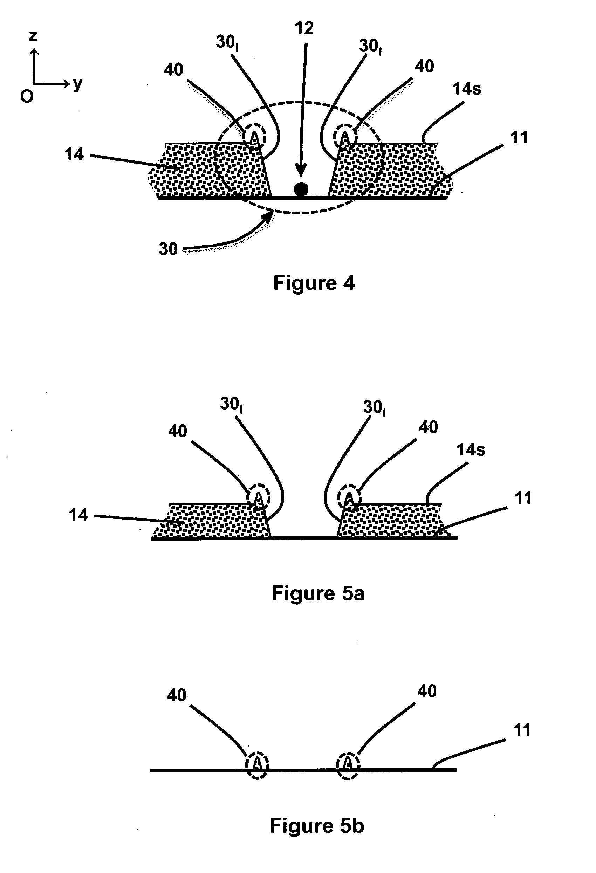

Comme illustré aux figures 3c et 4, l'étape de dépôt par enduction centrifuge de la résine 13 permet de former le trou 30 dans la couche 14. La couche 14 comporte une surface libre 14s opposée à la face 11 du substrat 10, et le trou 30 comporte des parois latérales 30l qui sont généralement inclinées par rapport à l'axe (Oz). Le trou 30 possède une forme évasée en partant de la face 11 du substrat 10 vers la surface libre 14s. Les parois latérales 30l et la surface libre 14s de la couche 14 en premier matériau sont reliées par un bourrelet 40 en premier matériau. Le bourrelet 40 est en saillie par rapport à la surface libre 14s qui est majoritairement plane.

Le procédé de réalisation de la couche 14 en premier matériau et du trou 30 engendre la formation du bourrelet 40 bordant le trou 30. Autrement dit, le bourrelet 40 peut être considéré comme une forme caractéristique de la formation par enduction centrifuge de la couche 14 en premier matériau et du trou 30.

Selon un mode particulier de réalisation illustré aux figures 5a et 5b, le procédé comporte également une étape de gravure. Après la formation du trou 30 et de son bourrelet 40, on réalise une gravure anisotrope du premier matériau pour former un motif fermé continu représentatif du pourtour du trou 30.

L'étape de gravure peut être configurée pour graver le premier matériau de la couche structurée 14 sur toute son épaisseur. Autrement dit, l'étape de gravure est configurée pour éliminer le premier matériau compris entre la surface libre 14s et la face 11 du substrat 10, pour ne laisser que le bourrelet 40 en saillie de la face 11, c'est-à-dire le surplus d'épaisseur.

Avantageusement, le dépôt et la structuration de la couche 14 en premier matériau, en association avec d'autres techniques de microfabrication, peut permettre la réalisation de formes complexes, notamment en résine polymère. A titre d'exemple, on peut utiliser ce procédé pour former des plots évasés, des couronnes, ou encore des pointes. Ce procédé de réalisation particulier est dépourvu de l'utilisation d'espaceurs.

Par ailleurs, la topographie du trou 30 dépend notamment :
- des dimensions et du matériau de la particule 12 ;
- du matériau de la résine 13 et de sa viscosité ; et
- de la rugosité de la face 11 du substrat 10.

Par topographie, on entend notamment l'inclinaison des parois latérales 30l et les dimensions du trou 30 selon un axe (Oy) sensiblement perpendiculaire à l'axe (Oz). Le trou 30 a généralement une forme d'un puits, ainsi ses dimensions selon l'axe (Oy) correspondent généralement aux diamètres des ouvertures du puits au niveau de la face 11 et au niveau de la surface libre 14s.

Dans le cas où la résine 13 et le substrat 10 sont fixés, la topographie du trou 30 peut être ajustée en choisissant un type de particules adéquat pour obtenir, par exemple, le diamètre du puits souhaité.

A titre d'exemple, dans un premier temps on choisira le matériau de la particule 12 en fonction de la résine 13. Selon l'affinité de la particule 12 vis-à-vis de la résine 13, le trou 30 sera plus ou moins large. Autrement dit, une particule à base d'un matériau présentant une forte répulsion vis-à-vis de la résine 13 engendrera un trou 30 plus large que si on utilise une particule 12 ayant une meilleure affinité vis-à-vis de la résine 13.

Après le choix du matériau, les dimensions de la particule 12 peuvent être optimisées pour former un trou 30 ayant sensiblement les dimensions visées. Cette optimisation peut être réalisée en effectuant un dépôt test. Pour des particules 12 sphériques, on peut par exemple disposer plusieurs particules 12 ayant des diamètres différents, pour ensuite choisir la particule ayant le diamètre optimum qui permet d'obtenir sensiblement le trou 30 avec les dimensions visées. Par ailleurs, dans la gamme de vitesse de centrifugation usuellement utilisée dans le domaine de la microélectronique, aucune dépendance entre la topographie du trou 30 et la vitesse d'enduction centrifuge, permettant de réaliser une couche 14 en premier matériau uniforme, n'a été constatée.

De manière générale, pour chaque nouveau couple particule 12 / résine 13 considéré, il est préférable de procéder à un étalonnage des dimensions du trou 30 formé en fonction des dimensions de la particule 12.

En outre, on peut également ajuster la largeur du trou 30 formé par le dépôt par enduction centrifuge, en optimisant la température de la résine 13 juste avant sa disposition sur le substrat 10. En effet, optimiser la température de la résine 13 engendre une optimisation de sa viscosité, ce qui a un impact direct sur le phénomène de démouillage de la résine autour de la particule 12. De ce fait, pour réaliser un trou 30 plus étroit avec la même résine et les mêmes particules, on peut par exemple abaisser la température de la résine avant le dépôt pour augmenter sa viscosité. De la même manière pour réaliser un trou 30 plus large avec la même résine et les mêmes particules, on peut par exemple augmenter la température de la résine avant le dépôt pour abaisser sa viscosité.

Le procédé selon l'invention permet de manière avantageuse de former un trou 30 ayant une dimension, selon un axe (Oy) sensiblement parallèle à la surface 11 du substrat 10, 2 à 20 fois plus grande que la dimension de la particule 12 selon l'axe (Oy), par exemple le diamètre d'une particule 12 sphérique.

Selon un mode de réalisation compatible avec ceux décrits ci-dessus, la couche structurée 14 en premier matériau est réticulée après l'étape de dépôt et de structuration par enduction centrifuge. La résine 13 étant déposée généralement à l'état liquide, l'étape de réticulation est avantageusement réalisée pour améliorer la tenue mécanique de la couche 14 en premier matériau formée et structurée par enduction centrifuge. La réticulation de la couche structurée peut être réalisée par tout moyen connu compatible avec la résine. A titre d'exemple, la réticulation peut être réalisée par irradiation lumineuse et/ou par un recuit thermique.

Selon un autre mode particulier de réalisation, la couche structurée 14 en premier matériau subit une étape de traitement thermique. Préférentiellement, la couche structurée 14 en premier matériau subit une étape de traitement thermique avant d'être réticulée par irradiation lumineuse. Par ailleurs, la couche 14 peut subir un traitement thermique, avant, pendant ou après la réticulation du polymère pour améliorer ses propriétés structurelles et mécaniques.

L'étape de traitement thermique de la couche 14 avant sa réticulation, permet de manière avantageuse d'affiner les dimensions du trou 30 formé ainsi que sa forme. Le traitement thermique permet une redistribution douce du premier matériau de la couche 14 autour du trou 30, ce qui peut engendrer un élargissement du trou et/ou un changement d'inclinaison des parois latérales 30l et de la hauteur du bourrelet 40.

Selon un deuxième exemple de réalisation, la couche 14 en polyépoxyde a subi un traitement thermique avant sa réticulation. Ce traitement thermique a été réalisé à une température de l'ordre de 60°C pendant 10 minutes. Les autres étapes de réalisation sont identiques à celles du premier exemple décrit ci-dessus. Cette étape de traitement thermique additionnelle, a permis de former des trous 30 ayant une largeur d'environ 20 µm, et des bourrelets avec une hauteur d'environ 2 µm.

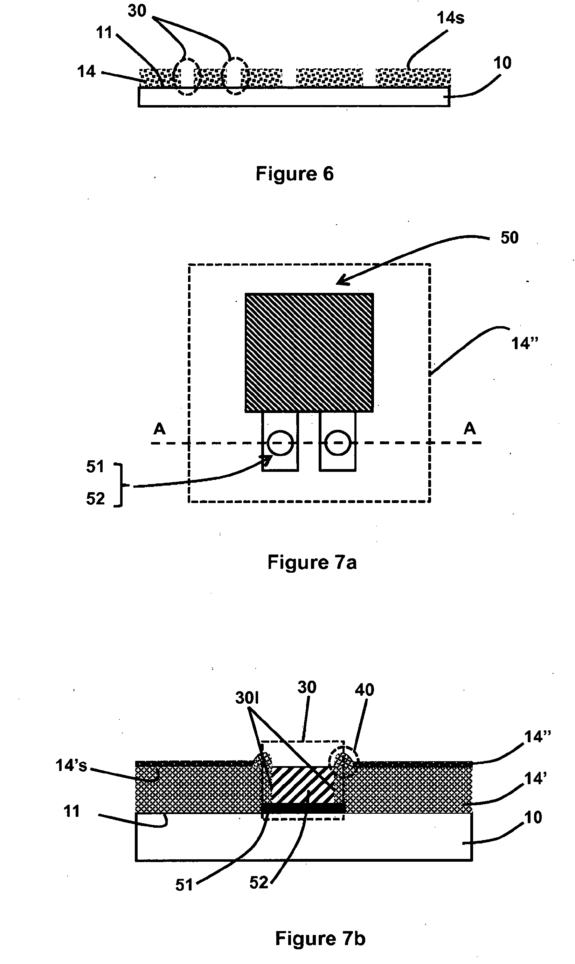

Selon un mode de réalisation particulier illustré à la figure 6, la particule 12 est éliminée de la face 11 du substrat 10, après la formation et la structuration de la couche 14 en premier matériau. La particule 12, n'est utilisée que pour engendrer le phénomène de démouillage et former le trou 30 dans la couche 14 en premier matériau.

Ce mode de mise en oeuvre permet de manière avantageuse de réaliser des trous qui comportent des parois latérales lisses ayant une faible rugosité, et un fond constitué par une portion de la face 11 du substrat 10, i.e. ayant la même rugosité de surface que la face 11 du substrat.

Dans le domaine des micro et nanotechnologies, une attention particulière est portée aux problématiques de contamination des substrats et des dispositifs. Ainsi, l'étape d'élimination de la particule 12, permet avantageusement d'éviter la contamination des substrats et des dispositifs lors des éventuelles étapes technologiques que la couche 14 devra subir.

L'élimination de la particule 12 sur la face 11 du substrat 10 dépend notamment de son matériau, de sa forme géométrique et de ses dimensions. A titre d'exemple, on peut utiliser des techniques de rinçage/nettoyage/traitement de surface des substrats, ou même des techniques de gravure chimique ou physique des particules. Toutes ces techniques sont usuellement utilisées dans le domaine de la microélectronique.

Selon les exemples de réalisation décrits ci-dessus, les microparticules 12 en ZnO sont éliminées par rinçage à l'eau déionisée, suivi d'un nettoyage ultrasons dans une solution alcoolique et enfin soufflage/séchage à l'aide d'une soufflette d'air comprimé.

Par ailleurs, dans le domaine d'encapsulation de composants électroniques, notamment des microbatteries, on utilise généralement une couche en matériau polymère disposée sur le composant. La couche de polymère permet à la fois de limiter les défauts liés à la rugosité du substrat sur lequel le composant a été réalisé, et de s'accommoder des déformations thermomécaniques du composant lors de son utilisation.

Cependant, une telle couche de polymère ne constitue pas une barrière efficace vis-à-vis de l'humidité et de l'oxygène, ce qui peut nuire à l'efficacité de fonctionnement dans le temps du composant. Ainsi, la couche de polymère est avantageusement surmontée par une couche métallique additionnelle formant une barrière de protection contre l'oxygène et l'humidité.

La disposition d'une telle couche métallique peut être réalisée d'une manière à entrer accidentellement en contact avec la prise de contact du composant, générant ainsi un court-circuit néfaste au fonctionnement du composant.

Ainsi, il existe un besoin de fournir un composant électronique muni d'une couche de polymère d'encapsulation, facile à réaliser et efficace tout en évitant les inconvénients cités ci-dessus.

On tend à satisfaire ce besoin en prévoyant un composant électronique comportant une couche d'encapsulation en polymère munie d'une séparation latérale de manière à isoler électriquement la prise de contact du composant et une couche métallique d'encapsulation.

Selon un mode particulier de réalisation illustré aux figures 7a et 7b, un composant électronique 50 est disposé sur une face 11 d'un substrat 10. Par composant électronique, on entend un dispositif électriquement connecté avec une source de génération électrique ou un autre dispositif en lui fournissant une puissance électrique. Préférentiellement, le composant 50 est un dispositif microélectronique, un dispositif MEMS ou une microbatterie, réalisés à partir du substrat 10 à base d'un matériau semi-conducteur.

Le composant 50 comporte au moins un premier plot 51 de contact électrique. Le plot 51 permet une prise de contact avec une connexion électrique de manière à relier électriquement le composant 50 avec un autre dispositif. A titre d'exemple, le plot 51 peut être à base d'un matériau métallique réalisé sur le substrat 10 par tout moyen connu.

En outre, le composant 50 comporte une première couche d'encapsulation 14' en matériau polymère électriquement isolant disposée sur la face 11 du substrat 10. La couche 14' comporte une surface 14's opposée à la face 11, et elle est préférentiellement en Epoxy. Par ailleurs, la première couche 14' est conformée de sorte à comporter un trou traversant 30 débouchant sur le plot 51. De préférence, la couche 14' est déposée par enduction centrifuge suivant le procédé de réalisation décrit ci-dessus.

Ainsi, une particule peut être disposée sur le plot 51, en utilisant par exemple la technique dite de « soft-lithography ». Un tampon texturé imprégné d'un solvant contenant la particule peut être pressé contre la face 11 du substrat 10 pour déposer la particule à un endroit précis, autrement dit, sur le plot 51. Le solvant est ensuite évaporé pour ne laisser que ladite particule. Ensuite, le dépôt de la résine à base du matériau polymère est déposée par enduction centrifuge de sorte à former le trou traversant 30. Par ailleurs, le trou traversant 30 comporte des parois latérales 30l reliées à la surface 14's par un bourrelet 40 en matériau polymère électriquement isolant.

Le composant 50 comporte également un deuxième plot 52 en matériau électriquement conducteur. Le deuxième plot 52 est disposé sur le premier plot 51 et il est localisé dans le trou 30. Préférentiellement, le deuxième plot 52 est à base d'un matériau métallique, par exemple en argent.

Pour former une barrière de protection contre l'oxygène et l'humidité, une deuxième couche d'encapsulation 14" électriquement conductrice est disposée sur la surface 14's. La deuxième couche 14" est disposée de sorte que les première et deuxième couches 14' et 14" d'encapsulation forment une bicouche recouvrant totalement le composant 50 à l'exception du deuxième plot 52.

En outre, les première et deuxième couche 14' et 14" sont conformées de sorte que le bourrelet 40 sépare latéralement le deuxième plot 52 et la deuxième couche d'encapsulation 14".

Le composant 50 comporte ainsi de manière avantageuse une isolation électrique latérale efficace est facile à réaliser entre sa prise de contact (le plot 52) et la couche d'encapsulation métallique.

Avantageusement, le deuxième plot 52 recouvre complétement les parois latérales 30l du trou 30, en laissant découvert uniquement le bourrelet 40. Cette disposition permet ainsi de protéger également les parois latérales 30l du trou 30 en matériau polymère par une couche métallique. Ainsi, on améliore l'étanchéité et l'efficacité de protection des première et deuxième couches d'encapsulation contre l'oxygène et l'humidité.

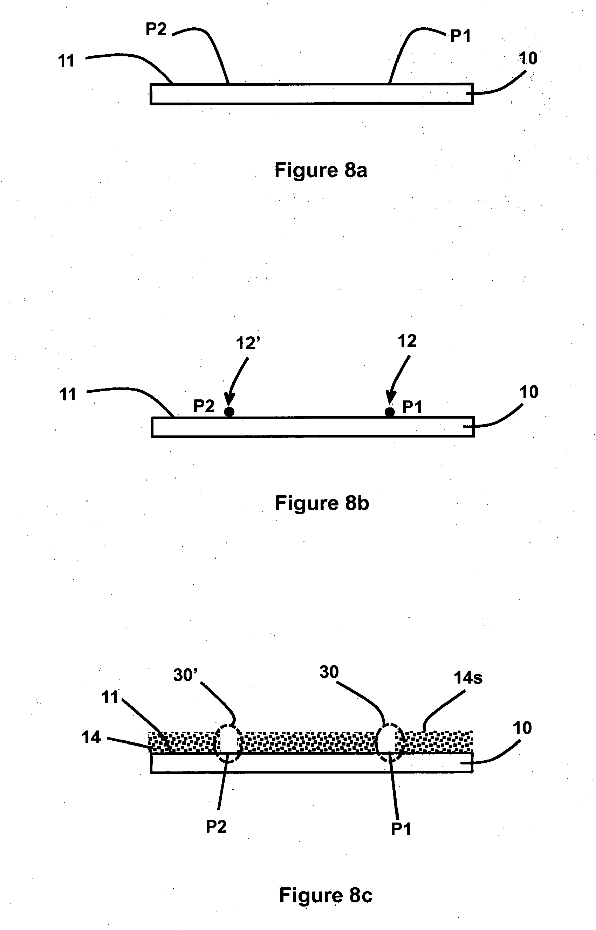

Selon un mode de mise en oeuvre avantageux de la couche structurée 14, au moins deux particules sont disposées sur le substrat. Comme illustré aux figures 8a à 8c, au moins une particule additionnelle 12' est disposée sur la face 11 du substrat 10 de manière que la particule 12 et la particule additionnelle 12' soient localisées à des première P1 et deuxième P2 positions prédéterminées de la face 11 du substrat 10. Par ailleurs, le matériau de la particule additionnelle 12' est choisi de manière que la particule additionnelle 12' exerce également une interaction répulsive vis-à-vis de la résine 13. La disposition des particules 12 et 12' sur la face 11 du substrat 10 permet de former, outre la couche 14 en premier matériau et le trou 30, un trou additionnel 30' traversant la couche 14 et débouchant sur la particule additionnelle 12'.

Ce mode de réalisation permet de manière avantageuse de former la couche en premier matériau et des trous à des endroits précis en utilisant la même étape de dépôt par enduction centrifuge.

Pour disposer les particules 12 et 12' à des endroits prédéterminés de la face 11 du substrat 10, plusieurs techniques peuvent être utilisées.

On peut utiliser la technique dite de « soft-lithography ». Par exemple, un tampon texturé imprégné d'un solvant contenant les particules 12 et 12' peut être pressé contre la face 11 du substrat 10 pour déposer les particules 12 et 12' à des endroits précis. Le solvant est ensuite évaporé pour ne laisser que les particules 12 et 12'.

Par ailleurs, les particules 12 et 12' peuvent être déposées à l'aide d'une pointe d'AFM par diffusion à travers un ménisque d'eau, ou encore par dépôt PVD (PVD pour « Physical Vapour Deposition »), CVD (CVD pour « Chemical Vapour Deposition »), électro-dépôt etc. En effet, les particules 12 et 12' peuvent être déposées sous la forme de couches ultra-minces, puis éliminées localement aux endroits où elles sont indésirables par photolithographie.

Après avoir disposer les particules 12 et 12' les autres étapes, notamment l'étape de dépôt par enduction centrifuge, sont identiques aux différentes étapes des autres modes de réalisation décrits ci-dessus.

Selon un autre mode de réalisation, les première P1 et deuxième P2 positions prédéterminées sont choisies de manière que le trou traversant 30 et le trou traversant additionnelle 30' se chevauchent. Cette disposition particulière des particules 12 et 12' permet de manière avantageuse de réaliser des motifs plus ou moins compliqués dans la couche 14 en premier matériau. A titre d'exemple, grâce à ce procédé inventif, des tranchées sont facilement réalisables dans la couche 14. Le procédé permet ainsi de réaliser des tranchées ayant un état de surface identique à celui du substrat 10, autrement dit en sauvegardant la rugosité.

## Revendications

1. Procédé de réalisation d'une couche (14) structurée en premier matériau sur une face (11) d'un substrat (10) comportant les étapes successives suivantes :
• disposer une particule (12) sur la face (11) du substrat (10) ;
• déposer par enduction centrifuge une résine (13) sur la face (11) du substrat (10) de manière à former la couche (14) structurée en premier matériau et un trou (30) traversant la couche (14) en premier matériau et débouchant sur la particule (12) ;
le matériau de la particule (12) et la résine (13) sont choisis de manière que la particule (12) exerce une interaction répulsive vis-à-vis de la résine (13).

2. Procédé selon la revendication 1 **caractérisé en ce qu'**après l'étape de dépôt par enduction centrifuge, la couche structurée (14) en premier matériau est réticulée.

3. Procédé selon l'une des revendications 1 et 2, **caractérisé en ce que** la couche structurée (14) en premier matériau subit une étape de traitement thermique.

4. Procédé selon l'une quelconque des revendications 1 à 3 **caractérisé en ce qu'**il comporte une élimination de la particule (12) après la formation de la couche structurée (14) en premier matériau.

5. Procédé selon l'une quelconque des revendications 1 à 4, **caractérisé en ce que** l'épaisseur de la couche structurée (14) est supérieure à la dimension de la particule (12) selon un axe (Oz) sensiblement perpendiculaire à la face (11) du substrat (10).

6. Procédé selon l'une quelconque des revendications 1 à 5 **caractérisé en ce qu'**il comporte la disposition d'au moins une particule additionnelle (12') sur la face (11) du substrat (10) de manière que la particule (12) et la particule additionnelle (12') soient localisées à des première (P1) et deuxième (P2) positions prédéterminées de la face (11) du substrat (10), et **en ce que** le matériau de la particule additionnelle (12') soit choisi de manière que la particule additionnelle (12') exerce une interaction répulsive vis-à-vis de la résine (13) de sorte à former un trou additionnel (30') traversant la couche (14) en premier matériau et débouchant sur la particule additionnelle (12').

7. Procédé selon la revendication 6, **caractérisé en ce que** les première (P1) et deuxième (P2) positions prédéterminées sont choisies de manière que le trou traversant (30) et le trou traversant additionnel (30') se chevauchent.

8. Procédé selon l'une quelconque des revendications 1 à 7, **caractérisé en ce que** le trou traversant (30) comporte des parois latérales (30l) et que la couche structurée (14) en premier matériau comporte une surface libre (14s) opposée à la face (11) du substrat (10), les parois-latérales (30l) et la surface libre (14s) sont reliées par un bourrelet (40) en premier matériau, le procédé comportant une gravure anisotrope du premier matériau pour former un motif fermé continu et représentatif du pourtour du trou (30).

9. Composant électronique (50) disposé sur une face (11) d'un substrat (10), et comportant :
• un premier plot (51) de contact électrique ;
• une première couche d'encapsulation (14') en matériau polymère électriquement isolant disposée sur la face (11) et munie d'une surface (14's) opposée à la face (11), ladite première couche (14') étant conformée de sorte à comporter un trou traversant (30) débouchant sur le plot (51) ;
• un deuxième plot (52) en matériau électriquement conducteur, disposé sur le premier plot (51) et localisé dans le trou (30) ;
• une deuxième couche d'encapsulation (14") électriquement conductrice disposée sur la surface (14's), les première et deuxième couches (14', 14") d'encapsulation formant une bicouche recouvrant totalement le composant (50) à l'exception du deuxième plot (52) ;
**caractérisé en ce que** le trou traversant (30) comporte des parois latérales (30l) reliées à la surface (14's) par un bourrelet (40) en matériau polymère électriquement isolant, le bourrelet (40) séparant latéralement le deuxième plot (52) et la deuxième couche d'encapsulation (14").

## Patentansprüche

1. Verfahren zur Ausführung einer strukturierten Schicht (14) aus einem ersten Material auf einer Fläche (11) eines Substrats (10) mit den aufeinanderfolgenden Schritten wie folgt:
- Anordnen eines Partikels (12) auf der Fläche (11) des Substrats (10);
- Aufbringen durch Tauchschleudern eines Harzes (13) auf die Fläche (11) des Substrats (10), um die strukturierte Schicht (14) aus einem ersten Material und ein Loch (30) zu bilden, das die Schicht (14) aus dem ersten Material durchquert und auf dem Partikel (12) mündet;
wobei das Material des Partikels (12) und das Harz (13) derart ausgewählt sind, dass der Partikel (12) eine abstoßende Wechselwirkung gegenüber dem Harz (13) ausübt.

2. Verfahren nach Anspruch 1, **dadurch gekennzeichnet, dass** nach dem Schritt des Aufbringens durch Tauchschleudern die strukturierte Schicht (14) aus dem ersten Material netzartig ist.

3. Verfahren nach einem der Ansprüche 1 und 2, **dadurch gekennzeichnet, dass** die strukturierte Schicht (14) aus dem ersten Material einem Wärmebehandlungsschritt unterzogen wird.

4. Verfahren nach einem der Ansprüche 1 bis 3, **dadurch gekennzeichnet, dass** es eine Beseitigung des Partikels (12) nach der Bildung der strukturierten Schicht (14) aus dem ersten Material umfasst.

5. Verfahren nach einem der Ansprüche 1 bis 4, **dadurch gekennzeichnet, dass** die Dicke der strukturierten Schicht (14) größer als die Abmessung des Partikels (12) entlang einer Achse (Oz) ist, die im Wesentlichen senkrecht zu der Fläche (11) des Substrats (10) verläuft.

6. Verfahren nach einem der Ansprüche 1 bis 5, **dadurch gekennzeichnet, dass** es die Anordnung von mindestens einem zusätzlichen Partikel (12') auf der Fläche (11) des Substrats (10) derart umfasst, dass der Partikel (12) und der zusätzliche Partikel (12') an einer ersten (P1) und einer zweiten (P2) vorgegebenen Position der Fläche (11) des Substrats (10) örtlich begrenzt werden, und dass das Material des zusätzlichen Partikels (12') derart ausgewählt wird, dass der zusätzliche Partikel (12') eine abstoßende Wechselwirkung gegenüber dem Harz (13) ausübt, um ein zusätzliches Loch (30') auszubilden, das die Schicht aus dem ersten Material durchquert und auf dem zusätzlichen Partikel (12') mündet.

7. Verfahren nach Anspruch 6, **dadurch gekennzeichnet, dass** die erste (P1) und die zweite (P2) vorgegebene Position derart ausgewählt werden, dass sich das durchquerende Loch (30) und das zusätzliche durchquerende Loch (30') überlappen.

8. Verfahren nach einem der Ansprüche 1 bis 7, **dadurch gekennzeichnet, dass** das durchquerende Loch (30) Seitenwände (301) aufweist und dass die strukturierte Schicht (14) aus dem ersten Material eine freie Oberfläche (14s) aufweist, die der Fläche (11) des Substrats (10) gegenüber liegt, wobei die Seitenwände (30l) und die freie Oberfläche (14s) über einen Wulst (40) aus dem ersten Material verbunden sind, wobei das Verfahren ein anisotropes Ätzen des ersten Materials umfasst, um ein geschlossenes durchgehendes und für den äußeren Umfang des Loches (30) repräsentatives Muster zu bilden.

9. Elektronisches Bauteil (50), das auf einer Fläche (11) eines Substrats (10) angeordnet ist und Folgendes aufweist:
- einen ersten elektrischen Kontaktpunkt (51);
- eine erste Verkapselungsschicht (14') aus elektrisch isolierendem Polymermaterial, die auf der Fläche (11) angeordnet ist und mit einer Oberfläche (14's) versehen ist, welche der Fläche (11) gegenüber liegt, wobei die erste Schicht (14') derart angepasst ist, dass sie ein durchquerendes Loch (30) umfasst, das auf dem Kontaktpunkt (51) mündet;
- einen zweiten Kontaktpunkt (52) aus elektrisch leitendem Material, der auf dem ersten Kontaktpunkt (51) angeordnet und in dem Loch (30) örtlich begrenzt ist;
- eine zweite, elektrisch leitende Verkapselungsschicht (14"), die auf der Oberfläche (14's) angeordnet ist, wobei die erste und die zweite Verkapselungsschicht (14', 14") eine Doppelschicht bilden, die das Bauteil (50) mit Ausnahme des zweiten Kontaktpunktes (52) vollständig bedeckt;
**dadurch gekennzeichnet, dass** das durchquerende Loch (30) Seitenwände (30l) aufweist, die mit der Oberfläche (14's) über einen Wulst (40) aus elektrisch isolierendem Polymermaterial verbunden sind, wobei der Wulst (40) den zweiten Kontaktpunkt (52) und die zweite Verkapselungsschicht (14") seitlich trennt.

## Claims

1. A method for producing a patterned layer (14) made from first material on a surface (11) of a substrate (10) comprising the following successive steps:
• arranging a particle (12) on the surface (11) of the substrate (10);
• depositing a resin (13) by spin coating on the surface (11) of the substrate (10) so as to form the patterned layer (14) of first material and a hole (30) passing through the layer (14) of first material and opening onto the particle (12);
• the material of the particle (12) and the resin (13) being chosen such that the particle(12) exerts a repulsive interaction with respect to the resin (13).

2. The method according to claim 1, **characterized in that** the patterned layer (14) of first material is cross-linked after the spin coating deposition step.

3. The method according to anyone of the claims 1 and 2, **characterized in that** the patterned layer (14) of first material undergoes a heat treatment step.

4. The method according to anyone of the claims 1 to 3, **characterized in that** it comprises an elimination of the particle (12) after formation of the patterned layer (14) of first material.

5. The method according to anyone of the claims 1 to 4, **characterized in that** the thickness of the patterned layer (14) is greater than the dimension of the particle (12) along an axis (Oz) substantially perpendicular to the surface (11) of the substrate (10).

6. The method according to anyone of the claims 1 to 5, **characterized in that** it comprises an arrangement of at least one additional particle (12') on the surface (11) of the substrate (10) so that the particle (12) and the additional particle (12') are located at first (P1) and second (P2) predefined positions of the surface (11) of the substrate (10), and **in that** the material of the additional particle (12') is chosen such that the additional particle exerts a repulsive interaction with respect to the resin (13) so as to form an additional hole (30') passing through the layer (14) of first material and opening onto the additional particle (12').

7. The method according to claim 6, **characterized in that** the first (P1) and second (P2) predefined positions are chosen such that the pass-through hole (30) and the additional pass-through hole (30') overlap.

8. The method according to anyone of the claims 1 to 7, **characterized in that** the pass-through hole (30) comprises side walls (30l) and that the patterned layer (14) of first material comprises a free surface (14s) opposite the surface (11) of the substrate (10), the side walls (30l) and the free surface (14s) are connected by a pad (40) made from first material, the method comprising anisotropic etching of the first material to form a continuous closed pattern representative of the periphery of the hole (30).

9. An electronic component (50) arranged on the surface (11) of a substrate (10), and comprising:
• a first pad (51) forming an electric contact;
• a first encapsulation layer (14') made from electrically insulating polymer material arranged on the substrate surface (11) and provided with a surface (14's) opposite the substrate surface (11), said first layer (14') being formed so as to comprise a pass-through hole (30) opening onto the first pad (51);
• a second pad (52) made from electrically conducting material, arranged on the first pad (51) and located in the hole (30);
• a second electrically conducting encapsulation layer (14") arranged on the surface (14's), the first and second encapsulation layers (14', 14") forming a bilayer totally covering the component (50) with the exception of the second pad (52);
**characterized in that** the pass-through hole (30) comprises side walls (30l) connected to the surface (14's) by a pad (40) made from electrically insulating polymer material, the said pad (40) laterally separating the second pad (52) and the second encapsulation layer (14").
